(19) Europäisches Patentamt
European Patent Office
Office européen des brevets

(11) Veröffentlichungsnummer: **0 190 998**
**B1**

(12) # EUROPÄISCHE PATENTSCHRIFT

(45) Veröffentlichungstag der Patentschrift: **26.10.88**

(21) Anmeldenummer: **86810055.3**

(22) Anmeldetag: **30.01.86**

(51) Int. Cl.⁴: **C 07 F 15/00**, C 08 G 59/14, C 08 G 59/22, C 08 J 3/24, C 08 L 63/00, C 09 J 3/16, H 01 B 1/12

(54) **Copolymerisierbare Dibenzalaceton-Palladiumkomplexe und deren Verwendung.**

(30) Priorität: **05.02.85 CH 514/85**

(43) Veröffentlichungstag der Anmeldung: **13.08.86 Patentblatt 86/33**

(45) Bekanntmachung des Hinweises auf die Patenterteilung: **26.10.88 Patentblatt 88/43**

(84) Benannte Vertragsstaaten: **CH DE FR GB IT LI NL SE**

(56) Entgegenhaltungen:
**DE - A - 2 426 879**
**DE - A - 2 451 217**

(73) Patentinhaber: **CIBA-GEIGY AG, Klybeckstrasse 141, CH-4002 Basel (CH)**

(72) Erfinder: **Tieke, Bernd, Dr., Oberdorf 434, CH-1711 Giffers (CH)**
Erfinder: **Zahir, Sheik Abdul-Cader, Dr., Elsternstrasse 12, CH-4104 Oberwil (CH)**
Erfinder: **Finter, Jürgen, Dr., Zasiusstrasse 100, D-7800 Freiburg/Br. (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



ACTORUM AG

**Beschreibung**

Die Erfindung betrifft neue copolymerisierbare Dibenzalaceton-Palladiumkomplexe, deren Herstellung, Gemische, welche erfindungsgemässe Palladiumkomplexe, ein Epoxidharz und einen Härter und/oder Härtungskatalysator enthalten, sowie die Verwendung dieser Gemische, z. B. als Klebstoffe oder zur Herstellung von gehärteten Produkten und besonders zur Herstellung von elektrisch leitenden Überzügen und Mustern.

Palladium-Dibenzalaceton-Komplexe wurden erstmals 1970 von Takahashi et al. [J. Chem. Soc. D 1970, 1065] beschrieben. Derartige Komplexe können als Hydrierkatalysatoren, zur Herstellung von $H_2O_2$ oder als Katalysator für die Olefin/Acetylenpolymerisation verwendet werden [vgl. z. B. DE-OS 2426879, US-PS 4.347.232 und JP-OS 53-132.527]. Aus der DE-OS 2451217 ist ferner bekannt, dass Lösungen von Komplexen aus Palladium, Triphenylphosphit und einer olefinisch oder acetylenisch ungesättigten organischen Verbindung mit 3–16 C-Atomen oder von Palladium-Dibenzalaceton-Komplexen für die stromlose Metallabscheidung auf Substraten, wie Metallen, oxidierten Metallen und Kunststoffen, eingesetzt werden können. Dabei werden die zu beschichtenden Substrate ein oder mehrere Male in eine Lösung der Palladium-Komplexe getaucht, bevorzugt in Benzol- oder Toluol-Lösungen, und auf 100–300°C erhitzt, wobei Palladium auf der Substrat-Oberfläche abgeschieden wird. Die so beschichteten Substrate eignen sich zur stromlosen Metallabscheidung.

Die durch Palladium katalysierte stromlose Metallabscheidung auf Epoxidharzen ist ebenfalls bekannt. Dabei muss die Epoxidharz-Oberfläche mit metallischem Pd(O) aktiviert werden. Pd(O) kann z. B. chemisch durch Zusatz von Reduktionsmitteln, wie $NaBH_4$, mit Formalinlösung oder thermisch durch Erhitzen auf hohe Temperaturen erzeugt werden.

Bekannte Aktivierbäder enthalten beispielsweise $(NH_4)_2PdCl_4$, $(NH_4)_2Pd(NO_3)_4$, $PdCl_2$, $PdCl_2/NH_4Cl$ oder Palladiumorganyle und Polymere [vgl. z. B. JP-OS 50-66.439, DE-OS 2116389, DE-OS 3146164 und DE-OS 3150985]. Schliesslich sind auch schon palladiumhaltige Epoxidharze beschrieben worden. Dabei kann das Palladium in kolloidaler Form, als Pulver, in Form von Salzen (Pd-Acetat, Pd-Bisacetylacrylat) oder Komplexen (Pd-Allylchlorid) oder als Hexamethylentetramin-Pd-Addukt vorliegen, wobei im letzteren Fall das Erhitzen auf 100°C die Freisetzung von Pd(O) bewirkt [vgl. z. B. JP-OS 52-133.385, JP-OS 58-100.668, Tr. Mosk. Khim. Tekhnol. Inst. in D. I. Mendeleeva, 95 (1977) 124 und JP-OS 49-128.832].

Gegenstand der Erfindung sind neue copolymerisierbare Verbindungen der Formel I

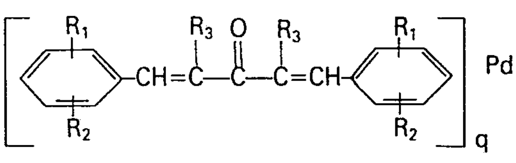

(I),

worin

$R_1$ –OH oder $-OCH_2CH—CH_2$ (O) und $R_2$ ein Wasserstoffatom, $C_{1-4}$-Alkyl, $C_{1-4}$-Alkoxy, Halogen, $C_{6-10}$-Aryl, $C_{7-8}$-Aralkyl oder $C_{7-8}$-Alkaryl bedeuten,

$R_3$ ein Wasserstoffatom oder $C_1$–$_4$-Alkyl ist oder die beiden $R_3$ zusammen eine Polymethylenkette mit 2–4 C-Atomen bilden und q 1 bis 3.5 darstellt.

Die Verbindungen der Formel I können auch in Form von Gemischen mit unterschiedlicher Bedeutung von q vorliegen; q ist vorzugsweise 2 bis 3,5.

Alkyl- bzw. Alkoxygruppen $R_2$ und $R_3$ können geradkettig oder verzweigt sein. Als Beispiele seien genannt: Methyl, Aethyl, n-Propyl, Isopropyl n-Butyl und sek.-Butyl; Methoxy, Aethoxy, n-Propoxy, n-Butoxy und sek-Butoxy. Als Halogenatome $R_2$ kommen vor allem Brom- und Chloratome in Betracht. Bedeutet $R_2$ Aryl, so handelt es sich zum Beispiel um 1- oder 2-Naphthyl und besonders Phenyl. Beispiele von definitionsgemässen Aralkyl- oder Alkarylgruppen $R_2$ sind Benzyl, α-und β-Phenyläthyl, Methylbenzyl, Tolyl, Xylyl und Aethylphenyl.

Bevorzugt stellen $R_2$ und $R_3$ je ein Wasserstoffatom dar.

$R_1$ ist vorzugsweise in m,m'- und insbesondere p,p'-Stellung gebunden und stellt bevorzugt $-OCH_2CH—CH_2$ (O) dar. Besonders bevorzugt sind Verbindungen der Formel I, worin $R_1$ $-OCH_2CH—CH_2$ (O) darstellt und $R_2$ und $R_3$ je ein Wasserstoffatom sind.

Die Verbindungen der Formel I können nach an sich bekannten Verfahren hergestellt werden [vgl. z. B. J. Chem. Soc. D, 1970, 1065 und US-PS 4.347.232], indem man q Mol einer Verbindung der Formel II

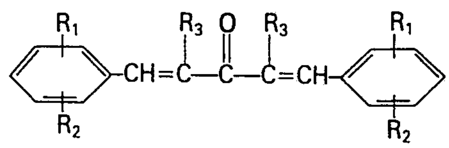

(II)

in Gegenwart einer Base und gegebenenfalls eines H-Donors mit einem löslichen Palladiumsalz umsetzt. Dabei haben $R_1$, $R_2$, $R_3$ und q die unter Formel I angegebene Bedeutung.

Als Basen können z. B. Alkalimetallsalze aliphatischer Monocarbonsäuren, besonders Kalium- und Natriumcetat, verwendet werden. Geeignete Palladiumsalze sind beispielsweise $PdBr_2$, $PdCl_2$ und $Na_2PdCl_4$. Besonders bevorzugt verwendet man $Na_2PdCl_4$ und vor allem $PdCl_2$. Die Umsetzung wird zweckmässig in einem organischen Lösungsmittel durchgeführt, das gleichzeitig auch als H-Donor fungiert. Dazu eignen sich z. B. Alkanole mit bis zu 6 C-Atomen, vor allem Aethanol und besonders bevorzugt Methanol.

Die Verbindungen der Formel II sind bekannt oder können auf an sich bekannte Weise hergestellt werden, beispielsweise analog dem in der US-PS 3.295.974 beschriebenen Verfahren.

Gegenstand der Erfindung sind auch härtbare Gemische, die

(a) mindestens eine Verbindung der Formel I,

(b) ein Epoxidharz oder Epoxidharz-Gemisch und

(c) einen hitzeaktivierbaren Härter und/oder einen Härtungskatalysator

enthalten.

Als Epoxidharze (b) kommen vor allem solche mit durchschnittlich mehr als einer an ein Heteroatom, z. B. an ein S- und vorzugsweise an ein O- oder N-Atom, gebundenen Gruppe der Formel III

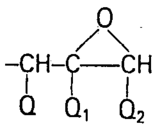 (III)

in Betracht, wobei Q und $Q_2$ je ein Wasserstoffatom und $Q_1$ ein Wasserstoffatom oder eine Methylgruppe bedeuten oder Q und $Q_2$ zusammen $-CH_2CH_2-$ oder $-CH_2CH_2CH_2-$ und $Q_1$ ein Wasserstoffatom bedeuten.

Als Beispiele solcher Harze seien Polyglycidyl- und Poly(β-methylglycidyl)ester genannt, die sich von aliphatischen, cycloaliphatischen oder aromatischen Polycarbonsäuren ableiten. Beispiele geeigneter Polycarbonsäuren sind Bernsteinsäure, Glutarsäure, Adipinsäure, Pimelinsäure, Korksäure, Azelainsäure, Sebacinsäure, dimerisierte und trimerisierte Linolsäure, Tetrahydrophthalsäure, 4-Methyltetrahydrophthalsäure, Hexahydrophthalsäure, 4-Methylhexahydrophthalsäure, Phthalsäure, Iso- und Terephthalsäure.

Weitere Beispiele sind Polyglycidyl- und poly(β-methylglycidyl)äther, die durch Umsetzung einer mindestens zwei alkoholische und/oder phenolische Hydroxylgruppen pro Molekül enthaltenden Verbindung mit Epichlorhydrin oder mit Allylchlorid und anschliessende Epoxidierung mit Persäuren erhalten werden.

Geeignete Polyole sind z. B. Aethylenglykol, Diäthylenglykol, Poly(oxyäthylen)glykole, Propan-1,2-diol, Poly(oxypropylen)glykole, Propan-1,3-diol, Butan-1,4-diol, Poly(oxytetramethylen)glykole, Pentan-1,5-diol, Hexan-2,4,6-triol, Glycerin, 1,1,1-Trimethylolpropan, Pentaerythrit und Sorbit; Resorcit, Chinit, Bis-(4-hydroxycyclohexyl)methan, 2,2-Bis-(4-hydroxycyclohexyl)propan und 1,1-Bis(hydroxymethyl)cyclohex-3-en; N,N-Bis(2-hydroxyäthyl)anilin und 4,4'-Bis(2-hydroxyäthylamino)diphenylmethan; Resorcin, Hydrochinon, Bis-(4-hydroxyphenyl)methan (Bisphenol F), 2,2-Bis(4-hydroxyphenyl)-propan (Bisphenol A), 2,2-Bis(4-hydroxy-3,5-dibromphenyl)propan (Tetrabrombisphenol A), 1,1,2,2-Tetrakis(4-hydroxyphenyl)äthan, 4,4'-Dihydroxybiphenyl, Bis-(4-hydroxyphenyl)sulfon sowie Novolake aus Formaldehyd oder Acetaldehyd und Phenol, Chlorphenol oder Alkylphenolen mit bis zu 9 C-Atomen im Alkyl, besonders Kresol- und Phenol-Novolake.

Als Poly(N-glycidyl)-Verbindungen kommen durch Dehydrochlorierung von Umsetzungsprodukten aus Epichlorhydrin und Aminen mit mindestens zwei Aminwasserstoffatomen erhaltene Produkte in Betracht. Geeignete Amine sind z. B. Anilin, n-Butylamin, Bis-(4-aminophenyl)-methan, 1,3- und 1,4-Xylylendiamin, 1,3- und 1,4-Bis(aminomethyl)-cyclohexan und Bis(4-methylaminophenyl)methan. Triglycidylisocyanurat, N,N'-Diglycidylderivate von cyclischen Alkylenharnstoffen, wie Aethylenharnstoff und 1,3-Propylenharnstoff, oder Hydantoinen, wie 5,5-Dimethylhydantoin, sind weitere geeignete derartige Verbindungen.

Poly(S-glycidyl)-Verbindungen sind z. B. die Di-S-Glycidylderivate von Dithiolen, wie Aethanol-1,2-dithiol und Bis-(4-mercaptomethylphenyl)-äther.

Beispiele für Epoxidharze mit einer oder mehreren Gruppen der Formel III, in welcher Q und $Q_2$ zusammen eine Gruppe $-CH_2CH_2-$ oder $-CH_2CH_2CH_2-$ bedeuten, sind Bis(2,3-epoxycyclopentyl)äther, 2,3-Epoxycyclopentylglycidyläther, 1,2-Bis(2,3-epoxycyclopentyloxy)äthan, 3,4-Epoxy-6-methylcyclohexylmethyl-3',4'-epoxy-6'-methylcyclohexancarboxylat und 2-(3,4-Epoxy)cyclohexyl-5,5-spiro(3',4'-epoxy)cyclohexan-dioxan.

Ebenfalls einsetzbar sind Epoxidharze, in welchen die Epoxidgruppen an Heteroatome verschiedener Art gebunden sind, oder in denen einige oder sämtliche Epoxidgruppen mittelständig sind, wie beispielsweise das N,N,O-Triglycidylderivat des 4-Aminophenols, N-Glycidyl-N'-(2-glycidyloxypropyl)-5,5-dimethylhydantoin, Vinylcyclohexendioxid, Limonendioxid und Dicyclopentadiendioxid.

Besonders bevorzugt setzt man als Komponente (b) gegebenenfalls vorverlängerte Diglycidyläther von zweiwertigen Phenolen, vor allem 2,2-Bis(4-hydroxyphenyl)propan, 2,2-Bis(3,5-dibrom-4-hydroxyphenyl)-propan, Bis(4-hydroxyphenyl)-methan, Bis(4-hydroxycyclohexyl)methan oder 2,2-Bis(4-hydroxycyclohexyl)propan, Polyglycidyläther von Novolaken, oder tetraglycidyliertes 4,4'-Diaminodiphenylmethan ein. Ganz besonders bevorzugt sind gegebenenfalls vorverlängerte Diglycidyläther von Bisphenol A, Tetrabrom-Bisphenol A oder Bisphenol F, Polyglycidyläther von Phenol-Formaldehyd- oder Kresol-Formaldehyd-Novolaken, oder Gemische davon.

Stellt $R_1$ in Formel I –OH dar, so kommen als Härter (c) z. B. aromatische und insbesondere aliphatische Aldehyde mit 1–6 C-Atomen, Polyisocyanate und Polyepoxide in Betracht.

Geeignete Polyisocyanate sind beispielsweise Verbindungen der Formel IV

$$O{=}C{=}N{-}X{-}N{=}C{=}O \qquad (IV),$$

worin X $-C_pH_p-$ mit p = 1–8, Cyclohexylen, Phenylen oder Tolylen darstellt, wie m- und p-Phenylendiisocyanat, 1,6-Hexamethylendiisocyanat und 2,4- oder 2,6-Tolylendiisocyanat.

Werden als Härter (c) Polyepoxide eingesetzt, so kommen Verbindungen der unter (b) genannten Art in Betracht. Die Komponenten (b) und (c) können somit in diesem Fall identisch sein.

Bevorzugte Härter (c) für OH-gruppenhaltige Verbindungen der Formel I sind Formaldehyd bzw. Paraformaldehyd und insbesondere Polyepoxide. Dabei gilt in bezug auf bevorzugte Epoxidharze das oben angegebene.

Als Härter für Verbindungen der Formel I mit $R_1 = -OCH_2\underbrace{CH-CH_2}_{O}$ eignen sich an sich beliebige Epoxidharzhärter, wie z. B. Cyanamid, Dicyandiamid, Polycarbonsäuren, Polycarbonsäureanhydride, Polyamine, Polyaminoamide, Addukte aus Aminen und Polyepoxiden und Polyole.

Geeignete Polycarbonsäuren und ihre Anhydride sind z. B. Phthalsäureanyhdrid, Tetrahydro- und Hexahydrophthalsäureanhydrid, Methyltetrahydrophthalsäureanhydrid, Methylenendomethylentetrahydrophthalsäureanhydrid, Endomethylentetrahydrophthalsäureanhydrid, Hexachlorendomethylentetrahydrophthalsäureanhydrid, Trimellitsäureanhydrid, Pyromellitsäuredianhydrid, Maleinsäureanhydrid, Bernsteinsäureanhydrid, Nonenylbernsteinsäureanhydrid, Dodecenylbernsteinsäureanhydrid, Polysebacinsäurepolyanhydrid und Polyazelainsäurepolyanhydrid sowie die zu den oben genannten Anhydriden gehörenden Säuren.

Als Beispiele von Polyaminen, die sich als Härtungsmittel eignen, seien aliphatische, cycloaliphatische, aromatische und heterocyclische Polyamine, wie Aethylendiamin, Propan-1,2-diamin, Propan1,3-diamin, N,N-Diäthyläthylendiamin, Hexamethylendiamin, Diäthylentriamin, Triäthylentetramin, Tetraäthylenpentamin, N-(2-Hydroxyäthyl)-, N-(2-Hydroxypropyl)-und N-(2-Cyanäthyl)-diäthylentriamin, 2,2,4- und 2,4,4-Trimethylhexan-1,6-diamin, m-Xylylendiamin, N,N-Dimethyl- und N,N-Diäthylpropan-1,3-diamin, Bis(4-amino-cyclohexyl)methan, 2,2-Bis(4-aminocyclohexyl)propan, 2,2-Bis(4-amino-3-methylcyclohexyl)propan, 3-Aminiomethyl-3,5,5-trimethylcyclohexylamin (Isophorondiamin), m- und p-Phenylendiamin, Bis(4-aminophenyl)-methan, Bis(4-aminophenyl-)sulfon, Anilin-Formaldehydharze und N-(2-Aminoäthyl)piperazin genannt. Geeignete Polyaminoamide sind z. B. solche, die aus aliphatischen Polyaminen und dimerisierten oder trimerisierten ungesättigten Fettsäuren hergestellt sind.

Als Addukte aus Aminen und Polyepoxiden kommen z. B. Addukte aus aliphatischen oder cycloaliphatischen Diaminen, wie 1,6-Hexamethylendiamin, 2,2,4- und 2,4,4-Trimethylhexan-1,6-diamin oder Isophorondiamin und den oben genannten Diglycidyläthern in Betracht.

Als Polyolhärter (c) kommen vor allem ein- oder mehrkernige aromatische Polyole, einschliesslich Novolake, in Betracht, wie Resorcin, Hydrochinon, 2,6-Dihydroxytoluol, Pyrogallol, 1,1,3-Tris(hydroxyphenyl)propan, Bis(4-hydroxyphenyl)methan, 2,2-Bis(4-hydroxyphenyl)propan, Bis(4-hydroxyphenyl)sulfon und 4,4'-Dihydroxybiphenyl sowie Novolake aus Formaldehyd oder Acetaldehyd und Phenol, Chlorphenol oder Alkylphenolen mit bis zu 9 C-Atomen im Alkyl, besonders Kresol- und Phenolnovolake.

Bevorzugte Härter für Verbindungen der Formel I mit Glycidyloxygruppen sind Polycarbonsäureanhydride, wie Tetrahydro-, Hexahydro- und Methyltetrahydrophthalsäureanhydrid, sowie aromatische Polyamine, besonders Bis(4-aminophenyl)-methan, Bis(4-aminophenyl)sulfon und m- oder p-Phenylendiamin.

Die Härter (c) werden in den in der Epoxidharztechnik üblichen Mengen eingesetzt, zweckmässig in solchen Mengen, dass auf ein Aequivalent OH- und/oder Glycidyloxygruppen etwa 0,7 bis 1,5 Aequivalente fuktioneller Gruppen des Härters (c) kommen.

Als Härtungskatalysatoren (c) können ebenfalls an sich bekannte Verbindungen verwendet werden. Als Beispiele seien genannt: Komplexe von Aminen, besonders tertiären Aminen, wie Monoäthylamin, Trimethylamin und Octyldimethylamin, mit Bortrifluorid oder Bortrichlorid, Asparaginsäuremonoester, wie der N-(3-Dimethylaminpropyl)-asparaginsäure-4-methylester, und insbesondere gegebenenfalls substituierte Imidazole, wie Imidazol, Benzimidazol, 1-Methylimidazol, 2-Aethyl-4-methylimidazol, 2-Vinylimidazol, 2-Phenylimidazol, 2-Phenyl-4-methylimidazol, 1-(2,6-Dichlorbenzoyl)-2-phenylimidazol und 1-(2,4,6-Trimethylbenzoyl)-2-phenylimidazol. Imidazole, besonders 2-Phenylimidazol und 2-Aethyl-4-methylimidazol, sind als Härtungskatalysatoren (c) bevorzugt.

Die erfindungsgemässen Gemische können als weitere Komponente (d) Härtungsbeschleuniger enthalten. Als Beschleuniger eignen sich z. B. tertiäre Amine, wie Benzyldimethylamin, Tris(dimethylaminomethyl)-phenol, Hexamethylentetramin oder 1,6-Bis(dimethylamino)hexan; aromatische Carbonate, wie Diphenylcarbonat, und Harnstoffderivate, wie N-4-Chlorphenyl-N',N'-dimethylharnstoff (Monuron), N-3-Chlor-4-methylphenyl-N',N'-dimethylharnstoff (Chlortoluron), N-(2-Hydroxyphenyl)-N',N'-dimethylharnstoff und N-(2-Hydroxy-4-nitrophenyl)-N,N-dimethylharnstoff. Tertiäre Amine, besonders Benzyldimethylamin, sind als Härtunsgbeschleuniger (d) bevorzugt.

Die Komponenten (c) und (d) werden in den üblichen wirksamen, d. h. für die Härtung der erfindungsgemässen Gemische ausreichenden Mengen eingesetzt. Das Verhältnis der Komponenten (a), (b), (c) und gegebenenfalls (d) hängt von der Art der verwendeten Verbindungen, der erforderlichen Härtungsgeschwindigkeit und den im Endprodukt gewünschten Eigenschaften ab und kann vom Fachmann auf dem Gebiet der Epoxidharz-Härtung leicht ermittelt werden. Die Menge an Palladiumkomplex der Formel I kann innerhalb weiter Grenzen variieren und liegt zweckmässig zwischen 0,01 und 60 Gew.%, besonders 0,1 und 40 Gew.%, bezogen auf das Gesamtgewicht des Gemisches.

Die erfindungsgemässen Gemische können – neben weiteren üblichen Zusätzen – auch elektrisch leitende Füllstoffe (e) enthalten, zweckmässig in Mengen von 1–90 Gew.%, besonders 40–80 Gew.%, bezogen auf das Gesamtgewicht des Gemisches, wobei sich die Komponenten (a) bis (e) auf 100 Gew.% ergänzen. Als elektrisch leitende Füllstoffe eignen sich solche organischer oder anorganischer Art, wie z. B. Russ und Graphit oder Metalle der Gruppen Vb, VIb, VIII und Ib des periodischen Systems, Legierungen und Salze davon, wie Halogenide, Oxide und Sulfide.

Beispiele geeigneter Metalle und Metallverbindungen sind: Vanadium, Niob, Tantal, Molybdän, Wolfram, Kupfer, Edelmetalle, wie Pt, Pd, Ag und Au, AgPd-Legierungen, Silberoxid, Silberjodid, Kupfer(II)sulfid, Kupfer(I)jodid, Kupfer(II)oxid, Gold(III)bromid, -jodid und -oxid, Molybdän(IV-)sulfid, Niob(V)chlorid und -oxid, Palladiumjodid, Palladiumoxid, Platin(IV)bromid und -chlorid, Vanadium(III)chlorid, Vanadium(IV)oxid, Wolfram(VI)chlorid und -oxid. Bevorzugt sind Silber, Kupfer, Silber/Palladiumlegierungen, Palladium, Platin, Gold, Wolfram und Molybdän. Besonders bevorzugt sind Au, Pt, AgPd und vor allem Ag und Cu-Pulver.

Die erfindungsgemässen Gemische können auch weitere bekannte und in der Epoxidharz-Technik übliche Zusatzstoffe enthalten. Beispiele für solche Zusatzstoffe sind Pigmente, Farbstoffe, Verstärkungsmaterialien, wie Glasfasern, Flammhemmer, reaktive Verdünner für die Epoxidharze, wie Phenyl- und Kresylglycidyläther, Butandioldiglycidyläther und Hexahydrophthalsäurediglycidyläther, Antistatika, Verlaufmittel, Trennmittel, Haftvermittler, Antioxidantien und Lichtschutzmittel.

Die Verbindungen der Formel I zeichnen sich durch gute Löslichkeit in Epoxidharzen aus, und die damit erhaltenen Lösungen weisen eine relativ niedrige Viskosität auf.

Die erfindungsgemässen Gemische finden z. B. Anwendung als Klebstoffe oder zur Herstellung gehärteter Produkte, besonders von Giesskörpern, Laminaten und dünnen Beschichtungen (Filmen).

Die Härtung der erfindungsgemässen Gemische erfolgt im allgemeinen durch Erhitzen auf Temperaturen zwischen 80 und 200°C, besonders 100 und 180°C. Dabei werden die Verbindungen der Formel I überraschenderweise in unzerstörter Form und feiner Verteilung in das Netzwerk der gehärteten Produkte einpolymerisiert, ohne dass dadurch die mechanischen Eigenschaften der gehärteten Produkte beeinträchtigt werden.

Durch eine thermische Behandlung der gehärteten Produkte bei erhöhten Temperaturen (Tempern) oder durch Bestrahlung mit aktinischem Licht kann eine Freisetzung von fein dispergiertem elementarem Palladium [Palladium(O)] bewirkt werden, das an die Harzoberfläche diffundiert und dort einen elektrisch leitenden Film bildet. Gegenstand der Erfindung ist somit auch die Verwendung der erfindungsgemässen Gemische zur Herstellung von elektrisch leitenden Überzügen und Mustern, besonders für gedruckte Schaltungen, indem man das Gemisch nach der Härtung bei erhöhten Temperaturen tempert oder mit aktinischem Licht bestrahlt.

Das Tempern erfolgt vorzugsweise bei Temperaturen oberhalb 220°C, insbesondere bei Temperaturen zwischen 220 und 250°C. Die Bestrahlung kann sowohl mit sichtbarem als auch UV-Licht bei einer Wellenlänge von 200–600 nm vorgenommen werden. Als Lichtquellen eignen sich beispielsweise Xenonlampen, Argonlampen, Wolframlampen, Kohlelichtbögen, Metallhalogenid- und Metallichtbogenlampen, wie Niederdruck-, Mitteldruck- und Hochdruck-Quecksilberlampen, Argonionen-Laser, frequenzverdoppelte Nd-YAG-Laser (yttriumaluminium garnet) und UV-Laser.

Bevorzugt ist die Bestrahlung mit sichtbarem Licht.

Die nach dem Tempern oder dem Bestrahlen mit aktinischem Licht erhaltenen elektrisch leitenden Überzüge oder Muster eignen sich vorzüglich für die stromlose Metallabscheidung, wobei elektrisch leitende metallische Überzüge oder Muster erhalten werden. Die stromlose Metallabscheidung kann mit an sich bekannten Metallisierungsbädern und nach üblichen Methoden durchgeführt werden. Als Metalle eignen sich beispielsweise Kupfer, Nickel, Kobalt, Silber und Zinn oder Kobalt-Phosphor- und Kobalt-Nickel-Legierungen.

Die Erfindung wird durch die folgenden Beispiele näher erläutert.

Beispiel 1: Herstellung von Tris(dibenzalaceton-bis-p,p'-glycidyläther)Palladium

15 g $PdCl_2$ werden in einer Lösung aus 10,7 g NaCl in 65 ml Wasser unter kräftigem Rühren zum Sieden erhitzt, bis das Palladiumchlorid vollständig gelöst ist. Dann wird das Wasser abdestilliert. Der Rückstand wird in 200 ml Methanol aufgenommen und auf 60°C erwärmt. 105,9 g Dibenzalaceton-bis-p,p'-diglycidyläther und 42,8 g Natriumacetat·$3H_2O$ werden zugesetzt, und es werden nochmals 175 ml Methanol zugegeben. Nach weiteren 15 Minuten bei 60°C wird die Mischung abgekühlt. Es entsteht ein Niederschlag, der unter Argon abfiltriert und einmal mit 100 ml Methanol, dreimal mit je 100 ml Wasser und noch zweimal mit 100 ml Methanol gewaschen wird. Anschliessend wird das Produkt bei 50°C im Vakuum getrocknet. Zur völligen Entfernung von restlichem Dibenzalaceton-bis-p,p'-diglycidyläther werden die Kristalle nochmals in 700 ml Methanol suspendiert und unter Argon abfiltriert. Anschliessend wird im Vakuum getrocknet. Man erhält 100,7 violetter Kristalle, die in Chloroform, Methylenchlorid, Benzol, Cyclohexan, Aceton, Aethylacetat und Cellosolve (2-Aethoxyäthanol) gut löslich sind. Weitere Eigenschaften des erhaltenen Komplexes sind in Tabelle I angegeben.

Beispiel 2: Herstellung des p,p'-Dihydroxydibenzalaceton-Palladium-Komplexes

Das in Beispiel 1 beschriebene Verfahren wird wiederholt, jedoch unter Verwendung von 71 g rekristallisiertem p,p'-Dihydroxydibenzalaceton anstelle von 105,9 g Dibenzalaceton-bis-p,p'-diglycidyläther. Bei der Aufarbeitung wird zweimal mit 30 ml Methanol und einmal mit 150 ml Aethylacetat gewaschen. Man erhält 55,6 % violetter Kristalle, die in Alkoholen, wie Methanol und Aethanol, in Benzol, Toluol, Aceton und 2-Aethoxyäthanol gut löslich sind. Weitere Eigenschaften des erhaltenen Komplexes sind in Tabelle I zusammengefasst.

Tabelle I

| Palladiumkomplex gemäss | Beispiel 1 | Beispiel 2 |
|---|---|---|
| C gefunden (%) | 66,25 | 53,14 |
| H gefunden (%) | 5,45 | 4,13 |
| Pd gefunden (%) | 8,10 | 24,6 |
| q gefunden | 3,2 | 1,1 |
| Ausbeute (%) | 97,4 | 55,6 |
| Zersetzungsbereich (°C) | 120–160 | 150–180 |
| Zersetzungsmaximum (°C) | 140 | 173 |

Beispiel 3:

25,7 g (34,8 Gew.%) eines Bispenol-A-Diglycidyläthers mit einem Epoxidgehalt von 5,25–5,4 Aequivalenten/kg, 18,6 g (25,1 Gew.%) des Palladium-Komplexes gemäss Beispiel 1 und 29,4 g (39,8 Gew.%) Hexahydrophthalsäureanhydrid werden bei 90°C während einer Stunde unter Rühren im Vakuum vermischt. Dann gibt man 0,22 g (0,3 Gew.%) Benzyldimethylamin als Beschleuniger zu. Nach weiterem 5minütigem Rühren bei 90°C wird die Mischung in eine auf 100°C vorgeheizte Form gegossen und dann 4 Stunden bei 100°C und 4 Stunden bei 120°C gehärtet. Die Eigenschaften des erhaltenen Formkörpers sind in Tabelle II zusammengefasst.

Beispiel 4:

44,8 g (54,6 Gew.%) des Bisphenol-A-Diglycidyläthers gemäss Beispiel 3 und 20,7 g (25,2 Gew.%) des Palladiumkomplexes gemäss Beispiel 1 werden 30 Minuten bei 90°C im Vakuum unter Rühren vermischt. Dann gibt man 16,6 g (20,2 Gew.%) 4,4'-Diaminodiphenylmethan zu und rührt während weiterer 10 Minuten bei 90°C unter Vakuum. Anschliessend wird die Mischung in eine auf 100°C vorgeheizte Form gegossen. Es wird 4 Stunden bei 100°C, 4 Stunden bei 120°C, 2 Stunden bei 150°C und 2 Stunden bei 180°C gehärtet. Die Eigenschaften des erhaltenen Formkörpers sind in Tabelle II zusammengefasst.

Beispiel 5:

8,0 g (25,2 Gew.%) des Palladiumkomplexes gemäss Beispiel 1 und 23,1 g (72,9 Gew.%) des Bisphenol-A-Diglycidyläthers gemäss Beispiel 3 werden während 30 Minuten unter Rühren bei 90°C im Vakuum gemischt. Dann gibt man 0,61 g (1,9 Gew.%) 2-Phenylimidazol als Härtungskatalysator zu. Nach weiterem 10minütigem Rühren bei 90°C im Vakuum wird die Mischung in eine auf 100°C vorgeheizte Form gegossen und 4 Stunden bei 100°C sowie 4 Stunden bei 120°C gehärtet. Die Eigenschaften des erhaltenen Formkörpers sind in Tabelle II zusammengefasst.

Beispiel 6:

Herstellung eines mehrschichtigen Epoxid-Glasfaserlaminats.

Es werden Lösungen folgender Zusammensetzung hergestellt:

(1) 6,3 g (25,0 Gew.%) des Palladiumkomplexes nach Beispiel 1, 11,5 g (46,0 Gew.%) eines festen Epoxidharzes auf der Basis von Bisphenol A mit einem Epoxidgehalt von 2,15–2,22 Aequiv./kg, 7,2 g (28,7 Gew.%) Hexahydrophthalsäureanhydrid, 0,1 g (0,3 Gew.%) Benzyldimethylamin, gelöst in 25 ml Dichlormethan.

(2) 100,0 g (77,9 Gew.%) eines festen Epoxidharzes auf der Basis von Bisphenol A mit einem Epoxidgehalt von 2,15–2,22 Akequiv./kg, 27,8 g (21,6 Gew.%) Hexahydrophthalsäureanhydrid, 0,4 g (0,3 Gew.%) Benzyldimethylamin, gelöst in 125 ml Dichlormethan.

(3) 3,7 g (14,8 Gew.%) des Palladiumkomplexes nach Beispiel 1, 3,7 g (14,9 Gew.%) Dibenzalaceton-diglycidylether, 14,3 g (57,0 Gew.%) eines festen Epoxidharzes auf Basis von Bisphenol A mit einem Epoxidgehalt von 2,15–2,22 Aequiv./kg, 3,3 g (13,3 Gew.%) 4,4'-Methylendianilin.

(4) 90,6 g (90,6 Gew.%) eines festen Epoxidharzes auf Basis von Bisphenol A mit einem Epoxidgehalt von 2,15–2,22 Aequiv./kg, 9,4 g (9,4 Gew.%) 4,4'-Methylendianilin; gelöst in 100 ml Dichlormethan.

Durch Eintauchen von Glasfasermatten in die Lösung (1), (2), (3) bzw. (4) und nachfolgendes Verdampfen des Lösungsmittels werden Prepregs hergestellt. 9 Prepregs der Lösung (2) werden mit 1 Prepreg der Lösung (1) bzw. 10 Prepregs der Lösung (4) werden mit 2 Prepregs der Lösung (3) beschichtet und durch jeweils sechsstündiges Härten bei 120°C zu stabilen Laminaten verpresst.

Beispiel 7:

Freisetzung metallischen Palladiums auf der Oberfläche von Giessharzen und Laminaten.

Eine Probe der nach den Beispielen 3, 4 und 5 hergestellten Giessharze bzw. des nach Beispiel 6 hergestellten Laminats werden bei ≥220°C während 1 Stunde an der Luft getempert. Es bildet sich ein elektrisch leitfähiger Palladiumfilm auf der Harzoberfläche (Leitfähigkeitswerte vgl. Tabelle II).

Beispiel 8:

Gezielte Freisetzung metallischen Palladiums auf der Oberfläche von Giessharzen und Laminaten.

Eine Probe der nach den Beispielen 3, 4 und 5 hergestellten Giessharze bzw. des nach Beispiel 6 hergestellten Laminats aus (1) und (2) werden während 3 Sekunden mit einem Laser bestrahlt ($\lambda$ = 514 nm, 18 A, 0,35 W). An den bestrahlten Stellen der Oberfläche wird ein Palladiumfilm abgeschieden.

Beispiel 9:

Stromlose Metallabscheidung

Die gemäss den Beispielen 7 und 8 vorbehandelten Giessharze und Laminate werden in ein handelsübliches Abscheidungsbad für die stromlose Verkupferung oder Vernickelung getaucht.

a) Verkupferungsbad A) SHIPLEY-Cuposit-® CP-78 bzw.

B) SHIPLEY-Cuposit® Copper Mix 328 Q. Badzusammensetzung entsprechend «Printed Circuits Handbook», 2. Auflage, C.F. Coombs, jr. et al.,

McGraw Hill Book Co., New York, 1979, S. 7–5: 25 g/l $CuSO_4 \cdot 5\ H_2O$, 60 g/l Natriumgluconat, 20 g/l NaOH, 25 g/l 37 %ige wässrige Formaldehydlösung, unter Sauerstoff-Strom. Arbeitstemperatur: 20°C.

b) Vernickelungsbad. Badzusammensetzung entsprechend J. Appl. Electrochem., 1 (1971) 167: 30 g/l $NiCl_2 \cdot 6\ H_2O$, 10 g/l $NaH_2PO_2 \cdot H_2O$, 50 g/l $NH_4Cl$, 82,4 g/l Natriumcitrat·2 $H_2O$.

Der pH des Bades wird mit konz. $NH_4OH$ auf 9 eingestellt. Arbeitstemperatur: 90°C.

Nach 1,5 Minuten bildet sich an den thermisch vorbehandelten Stellen der Harzoberfläche ein fest haftender Kupfer- bzw. Nickelfilm.

Tabelle II: Eigenschaften der Formkörper

| Formkörper gemäss Beispiel | 3 | 4 | 5 |
|---|---|---|---|
| dielektrischer Verlustfaktor tan δ [x10$^2$] | 0,89 (23°C) | 0,48 (26,4°C) | 0,48 (26,7°C) |
| Dielektrizitätszahl ε ($T_1$) | 3,5 (23°C) | 4,9 (26,4°C) | 4,5 (26,7°C) |
| Dielektrizitätszahl ε ($T_2$) | 3,5 (100°C) | 4,7 (100,5°C) | 4,6 (100,4°C) |
| spezifischer Durchgangswiderstand p [Ω cm] | 3,6x10$^{16}$ (23°C)<br>1,6x10$^{15}$ (100°C) | 2,5x10$^{15}$ (27°C)<br>7,3x10$^{14}$ (98,8°C) | 1,9x10$^{15}$ (26,4°C)<br>4,3x10$^{12}$ (100,4°C) |
| Biegefestigkeit nach DIN 53435 (N/mm$_2$) | 152,5 | 135,9 | n.b. |
| Biegewinkel [°] | 57,1 | 55,7 | n.b. |
| Bruchfestigkeit nach DIN 53435 [KJm$^{-2}$] | 7,1 | 12,7 | n.b. |
| Wasseraufnahme | | | |
| – nach 1 Stunde bei 100°C (%) | 0,31 | 0,51 | n.b. |
| – nach 4 Tagen bei 20 °C (%) | 0,33 | 0,50 | n.b. |
| Wärmeleitfähigkeit nach DIN 52612 [W/ (K·m)] | 0,250 | 0,291 | n.b. |
| Oberflächenleitfähigkeit nach 2stündigem Tempern bei 220°C [S cm$^{-1}$] | ≥10$^1$ | ≥10$^1$ | ≥10$^1$ |

n.b. = nicht bestimmt.

**Patentansprüche**

1. Verbindungen der Formel I

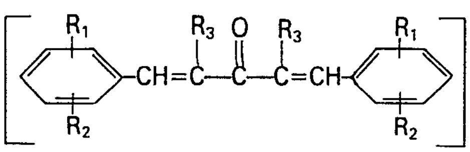

Pd (I),

worin $R_1$ –OH oder $-OCH_2\underbrace{CH-CH_2}_{O}$ und $R_2$ ein Wasserstoffatom, $C_{1-4}$-Alkyl, $C_{1-4}$-Alkoxy, Halogen, $C_{6-10}$-Aryl, $C_{7-8}$-Aralkyl oder $C_{7-8}$-Alkaryl bedeuten,

$R_3$ ein Wasserstoffatom oder $C_{1-4}$-Alkyl ist oder die beiden $R_3$ zusammen eine Polymethylenkette mit 2–4 C-Atomen bilden und q 1 bis 3,5 darstellt.

2. Verbindungen der Formel I nach Anspruch 1, worin q 2 bis 3,5 bedeutet.

3. Verbindungen der Formel I nach Anspruch 1, worin $R_2$ und $R_3$ je ein Wasserstoffatom bedeuten.

4. Verbindungen der Formel I nach Anspruch 1, worin $R_1$ $-OCH_2\underbrace{CH-CH_2}_{O}$ darstellt und $R_2$ und $R_3$ je ein Wasserstoff sind.

5. Verfahren zur Herstellung von Verbindungen der Formel I nach Anspruch 1, dadurch gekennzeichnet, dass man q Mol einer Verbindung der Formel II

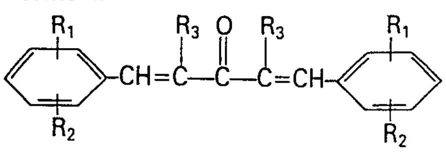

(II)

worin $R_1$, $R_2$, $R_3$ und q die im Anspruch 1 angegebene Bedeutung haben, in Gegenwart einer Base und gegebenenfalls eines H-Donors mit einem löslichen Palladiumsalz umsetzt.

6. Verfahren nach Anspruch 5, dadurch gekennzeichnet, dass man als Palladiumsalz $Na_2PdCl_4$ oder $PdCl_2$ verwendet und die Umsetzung in Gegenwart von Natrium- oder Kaliumacetat in einem Alkanol als H-Donor, besonders Methanol, vornimmt.

7. Härtbare Gemische enthaltend

(a) mindestens eine Verbindung der Formel I nach Anspruch 1,

(b) ein Epoxidharz oder Epoxidharz-Gemisch und

(c) einen hitzeaktivierbaren Härter und/oder einen Härtungskatalysator.

8. Härtbare Gemische nach Anspruch 7, die als Epoxidharze (b) solche mit durchschnittlich mehr als einer an ein S-, O- oder N-Atom gebundenen Gruppe der Formel III

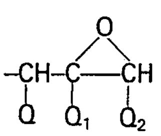

(III)

enthalten, worin Q und $Q_2$ je ein Wasserstoffatom und $Q_1$ ein Wasserstoffatom oder eine Methylgruppe bedeuten oder Q und $Q_2$ zusammen $-CH_2CH_2-$ oder $-CH_2CH_2CH_2-$ und $Q_1$ ein Wasserstoffatom bedeuten.

9. Härtbare Gemische nach Anspruch 7, die als Epoxidharze (b) gegebenenfalls vorverlängerte Diglycidyläther von 2,2-Bis(4-hydroxyphenyl)propan, 2,2-Bis(3,5-dibrom-4-hydroxyphenyl)propan, Bis(4-hydroxyphenyl)methan, Bis(4-hydroxycyclohexyl)methan oder 2,2-Bis(4-hydroxycyclohexyl)propan, Polyglycidyläther von Novolaken oder tetraglycidyliertes 4,4'-Diaminodiphenylmethan enthalten.

10. Härtbare Gemische nach Anspruch 7, die als Epoxidharz (b) gegebenenfalls vorverlängerte Diglycidyläther von Bisphenol A, Tetrabrom-Bisphenol A oder Bisphenol F, Polyglycidyläther von Phenol-Formaldehyd- oder Kresol-Formaldehyd-Novolaken oder Gemische davon enthalten.

11. Härtbare Gemische nach Anspruch 7, die bei $R_1$ = –OH als Härter einen aromatischen Aldehyd oder einen aliphatischen Aldehyd mit 1–6 C-Atomen, ein Polyisocyanat oder Polyepoxid enthalten.

12. Härtbare Gemische nach Anspruch 7, die bei $R_1$ = 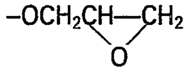 als Härter (c) ein Polycarbonsäureanhydrid oder ein aromatisches Polyamin enthalten.

13. Härtbare Gemische nach Anspruch 7, die bei $R_1$ = 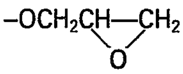 als Härtungskatalysator (c) ein Imidazol, besonders 2-Phenylimidazol oder 2-Aethyl-4-methylimidazol, enthalten.

14. Härtbare Gemische nach Anspruch 7, die zusätzlich (d) einen Härtungsbeschleuniger enthalten.

15. Härtbare Gemische nach Anspruch 14, worin der Beschleuniger ein tertiäres Amin, besonders Benzyldimethylamin, ist.

16. Härtbare Gemische nach Anspruch 7, die bezogen auf das Gesamtgewicht des Gemisches, 0,1 bis 40 Gew.% einer Verbindung der Formel I enthalten.

17. Härtbare Gemische nach Anspruch 7, die zusätzlich (e) einen elektrisch leitenden Füllstoff enthalten.

18. Verwendung von Gemischen nach Anspruch 7 als Klebstoffe oder zur Herstellung von gehärteten Produkten, besonders Giesskörpern, Laminaten oder Filmen.

19. Verwendung von Gemischen nach Anspruch 7 zur Herstellung von elektrisch leitenden Überzügen oder Mustern, dadurch gekennzeichnet, dass man das Gemisch nach der Härtung bei erhöhten Temperaturen tempert oder mit aktinischem Licht bestrahlt.

20. Verwendung von Gemischen nach Anspruch 7 für die stromlose Metallabscheidung auf elektrisch leitenden Überzügen oder Mustern, dadurch gekennzeichnet, dass man das Gemisch nach der Härtung bei erhöhten Temperaturen tempert oder mit aktinischem Licht bestrahlt und auf den erhaltenen Überzügen oder Mustern stromlos Metall abscheidet.

21. Verwendung nach einem der Ansprüche 18–20, worin das Gemisch zusätzlich einen elektrisch leitenden Füllstoff enthält.

## Claims

1. A compound of formula I

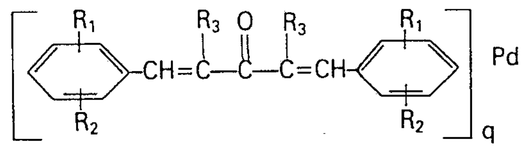

Pd (I),

in which $R_1$ is –OH or 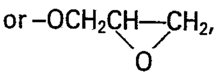

$R_2$ is a hydrogen atom, $C_1$–$C_4$alkyl, $C_1$–$C_4$alkoxy, halogen, $C_6$–$C_{10}$-aryl, $C_7$–$C_8$aralkyl or $C_7$–$C_8$alkaryl, $R_3$ is a hydrogen atom or $C_1$–$C_4$alkyl or both $R_3$ together form a polymethylene chain having 2 to 4 carbon atoms and q is 1 to 3,5.

2. A compound of formula I according to claim 1, in which q is 2 to 3,5.

3. A compound of formula I according to claim 1, in which each of $R_2$ and $R_3$ is a hydrogen atom.

4. A compound of formula I according to claim 1, in which $R_1$ is 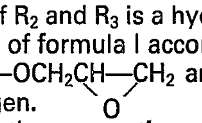 and each of $R_2$ and $R_3$ is a hydrogen.

5. A process for the preparation of a compound of formula I according to claim 1, which process comprises reacting q moles of a compound of formula II

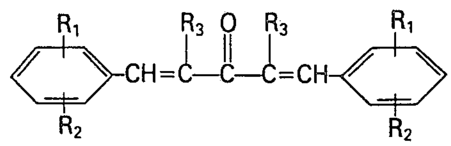

(II)

in which $R_1$, $R_2$, $R_3$ and q are as defined in claim 1, with a soluble palladium salt, in the presence of a base and, optionally, of a hydrogen donor.

6. A process according to claim 5, wherein the palladium salt used is $Na_2PdCl_4$ or $PdCl_2$ and the reaction is carried out in the presence of sodium acetate or potassium acetate in an alkanol as hydrogen donor, especially methanol.

7. A curable mixture containing

(a) at least one compound of formula I according to claim 1,

(b) an epoxy resin or a mixture of epoxy resins and

(c) a curing agent which can be activated by heat and/or a curing catalyst.

8. A curable mixture according to claim 7, which contains as epoxy resin (b) an epoxy resin having on average more than one group of formula (III)

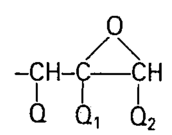

(III)

which is attached to a sulfur, oxygen or nitrogen atom and in which each of Q and $Q_2$ is a hydrogen atom and $Q_1$ is a hydrogen atom or a methyl group or Q and $Q_2$ together are $-CH_2CH_2-$ or $-CH_2CH_2CH_2-$ and $Q_1$ is a hydrogen atom.

9. A curable mixture according to claim 7, which contains as epoxy resin (b) a diglycidyl

ether or an advanced diglycidyl ether of 2,2-bis(4-hydroxyphenyl)propane, 2,2-bis(3,5-dibromo-4-hydroxyphenyl)-propane, bis(4-hydroxyphenyl)-methane, bis(4-hydroxycyclohexyl)methane or 2,2-bis(4-hydroxycyclohexyl)propane, a polyglycidyl ether of a novolak, or tetraglycidylated 4,4'-diaminodiphenylmethane.

10. A curable mixture according to claim 7, which contains as epoxy resin (b) a diglycidyl ether or an advanced diglycidyl ether of bisphenol A, tetrabromobisphenol A or bisphenol F, a polyglycidyl ehter of a phenol/formaldehyde novolak or cresol/formaldehyde novolak or a mixture thereof.

11. A curable mixture according to claim 7, which, if $R_1$ = OH, contains as curing agent an aromatic aldehyde or an aliphatic aldehyde having 1 to 6 carbon atoms, a polyisocyanate or polyepoxide.

12. A curable mixture according to claim 7, which, if $R_1$ = 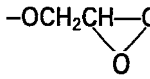 contains as curing agent (c) a polycarboxylic anhydride or an aromatic polyamine.

13. A curable mixture according to claim 7, which, if $R_1$ = 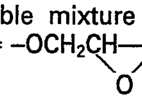 contains as curing catalyst (c) an imidazole, in particular 2-phenylimidazole or 2-ethyl-4-methylimidazole.

14. A curable mixture according to claim 7, which additionally contains (d) a curing accelerator.

15. A curable mixture according to claim 14, in which the accelerator is a tertiary amine, in particular benzyldimethylamine.

16. A curable mixture according to claim 7, which contains 0,1 to 40% by weight of a compound of formula I, based on the total weight of the mixture.

17. A curable mixture according to claim 7, which additionally contains (e) an electrically conductive filler.

18. Use of a mixture according to claim 7 as adhesive or for the preparation of cured products, in particular castings, laminates or films.

19. Use of a mixture according to claim 7 for the preparation of electrically conductive coatings or patterns, which comprise, after curing, tempering the mixture at elevated temperatures or irradiating said mixture with actinic light.

20. Use of a mixture according to claim 7 for electroless metal deposition on electrically conductive coatings or patterns, which comprises, after curing, tempering the mixture at elevated temperatures or irradiating said mixture with actinic light, and electrolessly depositing metal on the coatings or patterns obtained.

21. Use according to any one of claims 18 to 20, in which the mixture additionally contains en electrically conductive filler.

**Revendications**

1. Composés répondant à la formule I:

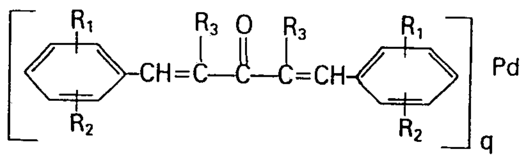 (I),

dans laquelle:

$R_1$ représente un radical –OH ou 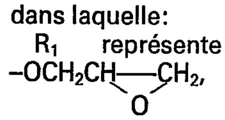

$R_2$ représente un atome d'hydrogène, un alkyle en $C_1$–$C_4$, un alcoxy en $C_1$–$C_4$, un halogène, un aryle en $C_6$–$C_{10}$, un aralkyle en $C_7$ ou $C_8$ ou un alkylaryle en $C_7$ ou $C_8$,

$R_3$ représente un atome d'hydrogène ou un alkyle en $C_1$–$C_4$, ou les deux $R_3$ forment ensemble une chaîne polyméthylène contenant de 2 à 4 atomes de carbone et q représente un nombre de 1 à 3,5.

2. Composés de formule I selon la revendication 1 dans lesquels q désigne un nombre de 2 à 3,5.

3. Composés de formule I selon la revendication 1 dans lesquels $R_2$ et $R_3$ représentent chacun un atome d'hydrogène.

4. Composés de formule I selon la revendication 1 dans lesquels $R_1$ représente un radical 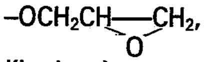 et $R_2$ et $R_3$ représentent chacun l'hydrogène.

5. Procédé pour préparer des composés de formule I selon la revendication 1, procédé caractérisé en ce qu'on fait réagir q mol d'un composé répondant à la formule II:

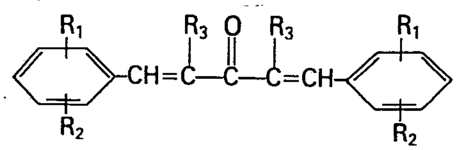 (II)

dans laquelle $R_1$, $R_2$, $R_3$ et q ont les significations données à la revendication 1, en présence d'une base et, éventuellement, d'un donneur d'hydrogène, avec un sel de palladium soluble.

6. Procédé selon la revendication 5 caractérisé en ce qu'on utilise, comme sel de palladium, $Na_2PdCl_4$ ou $PdCl_2$, et en ce qu'on effectue la réaction en présence d'acétate de sodium ou d'acétate de potassium dans un alcanol servant de donneur d'hydrogène, en particulier dans le méthanol.

7. Mélanges durcissables qui contiennent:

(a) au moins un composé de formule I selon la revendication 1,

(b) une résine époxydique ou un mélange de résines époxydiques et

(c) un durcisseur thermo-activable et/ou un catalyseur de durcissement.

8. Mélanges durcissables selon la revendication 7, caractérisés en ce qu'ils contiennent, comme résines époxydiques (b), des résines de ce type qui contiennent en moyenne plus d'un radical répondant à la formule III:

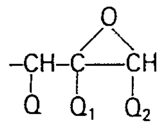

(III)

dans laquelle Q et $Q_2$ représentent chacun un atome d'hydrogène, auquel cas $Q_1$ représente un atome d'hydrogène ou un radical méthyle, ou Q et $Q_2$ forment ensemble un radical $-CH_2CH_2-$ ou $-CH_2CH_2CH_2-$, auquel cas $Q_1$ représente l'hydrogène, relié à un atome de soufre, d'oxygène ou d'azote.

9. Mélanges durcissables selon la revendication 7 qui contiennent, comme résines époxydiques (b), des éthers diglycidyliques, éventuellement pré-allongés, du bis-(hydroxy-4 phényl)-2,2 propane, du bis-(dibromo-3,5 hydroxy-4 phényl)-2,2 propane, du bis-(hydroxy-4 phényl)-méthane, du bis-(hydroxy-4 cyclohexyl)-méthane ou du bis-(hydroxy-4 cyclohexyl)-2,2 propane, des éthers polyglycidyliques de novolaques, ou du diamino-4,4' diphénylméthane tétraglycidylé.

10. Mélanges durcissables selon la revendication 7 qui contiennent, comme résines époxydiques (b), des éthers diglycidyliques, éventuellement pré-allongés, du bis-phénol A, du tétrabromo-bis-phénol A ou du bis-phénol F, des éthers polyglycidyliques de novolaques phénol/formaldéhyde ou crésol/formaldéhyde, ou des mélanges de ces composés.

11. Mélanges durcissables selon la revendication 7 dans lesquels $R_1$ représente un radical –OH et qui contiennent, comme durcisseur, un aldéhyde aromatique, un aldéhyde aliphatique en $C_1$–$C_6$, un poly-isocyanate ou un polyépoxyde.

12. Mélanges durcissables selon la revendication 7 dans lesquels $R_1$ représente un radical 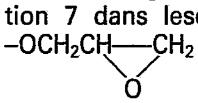 et qui contiennent, comme durcisseur (c), un anhydride d'acide polycarboxylique ou une polyamine aromatique.

13. Mélanges durcissables selon la revendication 7 dans lesquels $R_1$ représente un radical 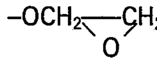 et qui contiennent, comme catalyseur de durcissement (c), un imidazole, en particulier le phényl-2 imidazole ou l'éthyl-2 méthyl-4 imidazole.

14. Mélanges durcissables selon la revendication 7 qui contiennent en outre (d) un accélérateur de durcissement.

15. Mélanges durcissables selon la revendication 14 dans lesquels l'accélérateur est une amine tertiaire, en particulier la benzyl-diméthylamine.

16. Mélanges durcissables selon la revendication 7 qui contiennent, par rapport au poids total du mélange, de 0,1 à 40 % en poids d'un composé de formule I.

17. Mélanges durcissables selon la revendication 7 qui contiennent en outre (e) une charge conductrice de l'électricité.

18. Application de mélanges selon la revendication 7 comme colles ou pour la fabrication de produits durcis, en particulier d'objets coulés, de stratifiés ou de pellicules.

19. Application de mélanges selon la revendication 7 à la fabrication de revêtements ou de dessins conducteurs de l'électricité, application caractérisée en ce que le mélange, après avoir été durci, est cuit à des températures élevées ou est exposé à un rayonnement actinique.

20. Application de mélanges selon la revendication 7 pour le dépôt de métaux sans courant sur des revêtements ou des dessins conducteurs de l'électricité, application caractérisée en ce que le mélange, après avoir été durci, est cuit à des températures élevées ou est exposé à un rayonnement actinique et en ce qu'un métal est déposé sans courant sur les revêtements ou dessins ainsi obtenus.

21. Application selon l'une des revendications 18 à 20, selon laquelle le mélange contient en outre une charge conductrice de l'électricité.